## Europäisches Patentamt
## European Patent Office
## Office européen des brevets

(11) Numéro de publication: **0 218 508**
**B1**

(12) **FASCICULE DE BREVET EUROPEEN**

(45) Date de publication du fascicule du brevet:
**03.10.90**

(51) Int. Cl.⁵: **H03L 7/18**

(21) Numéro de dépôt: **86402025.0**

(22) Date de dépôt: **16.09.86**

(54) Générateur de fréquences à variation rapide.

(30) Priorité: **17.09.85 FR 8513757**

(43) Date de publication de la demande:
**15.04.87 Bulletin 87/16**

(45) Mention de la délivrance du brevet:
**03.10.90 Bulletin 90/40**

(84) Etats contractants désignés:
**DE GB IT**

(56) Documents cités:
**DE-A- 3 122 161**
**FR-A- 2 021 675**
**FR-A- 2 196 549**

(73) Titulaire: **THOMSON-CSF, 51, Esplanade du Général de Gaulle, F-92800 Puteaux(FR)**

(72) Inventeur: **Attali, Dominique, THOMSON-CSF SCPI 19, avenue de Messine, F-75008 Paris(FR)**

(74) Mandataire: **Courtellemont, Alain et al, THOMSON-CSF SCPI, F-92045 PARIS LA DEFENSE CEDEX 67(FR)**

ACTORUM AG

## Description

La présente invention concerne un générateur de fréquence à variation rapide, utilisable, par exemple, comme hétérodyne à commutation rapide.

De tels générateurs sont connus. C'est ainsi qu'il existe des générateurs comportant une seule boucle de régulation, de type classique, qui fournissent un signal de bonne qualité spectrale mais dans lesquels l'augmentation de rapidité se fait au détriment du pas de synthèse. Il est également connu de réaliser des générateurs à division fractionnaire permettant d'aillier les performances de rapidité et de pas de synthèse mais, par leur principe même, ces générateurs sont sujets à une importante instabilité de phase (jitter dans la littérature anglo-saxonne) qu'il faut compenser pour conserver une bonne qualité spectrale; or les dispositifs de compensation utilisés à cet effet, sont complexes et augmentent de façon importante la consommation d'énergie et le prix de revient de ces générateurs. Il existe aussi des générateurs de fréquences à variation rapide comportant plusieurs boucles de régulation; ces générateurs associent, à leur rapidité, un faible pas de synthèse et une bonne qualité spectrale du signal fourni mais ils ne peuvent pas toujours être utilisés du fait de leur consommation d'énergie, de leur encombrement et de leur prix.

Le but de la présente invention est de permettre la réalisation d'un générateur de fréquences à variation rapide dans lequel les inconvénients mentionnés ci-avant sont évités ou, pour le moin, réduits.

Ceci est obtenu grâce à un synthétiseur de fréquences à division fractionnaire dans lequel des moyens sont mis en œuvre pour masquer l'instabilité de phase.

Selon l'invention un générateur de fréquences à variation rapide, du type à division fractionnaire, comportant un comparateur de phase ayant une première entrée couplée à une entrée de signal de comparaison du générateur et une seconde entrée, un oscillateur variable ayant une entrée de commande couplée au comparateur, et une sortie qui constitue la sortie du générateur, et, entre l'oscillateur et la seconde entrée du comparateur de phase, un diviseur à rang variable, est caractérisé en ce que, dans le but d'éviter que l'instabilité de phase due à la division fractionnaire dégrade le spectre du signal de sortie du générateur, il comporte, en série entre le comparateur et l'entrée de commande de l'oscillateur, un circuit de fenêtre qui tronque la durée de chaque signal fourni par le comparateur, d'une valeur T donnée, fonction de la durée maximum de l'écart de phase dû à la division fractionnaire dans la bande des fréquences d'utilisation du générateur.

Il est à noter, par ailleurs, que le document DE-A 3 122 161 décrit un générateur de fréquence étalon, du type pour appareil de mesure, qui comporte un asservissement de précision en fréquence par synthèse à rang fractionnaire; un tel générateur n'a pas les possibilités de commutation rapide d'une fréquence à une autre, qui sont recherchées dans les générateurs dits à variation rapide.

La présente invention sera mieux comprise et d'autres caractéristiques apparaîtront à l'aide de la description ci-après et des figures s'y rapportant qui représentent:

- la figure 1, un schéma électrique d'un générateur de fréquences selon l'invention,
- les figures 2, 4 et 5 des vues plus détaillées de parties du générateur de la figure 1,
- la figure 3 un diagramme des temps,
- la figure 6, un schéma électrique illustrant une variantre au générateur selon la figure 1.

Sur les différentes figures les éléments correspondants sont désignés par les mêmes repères.

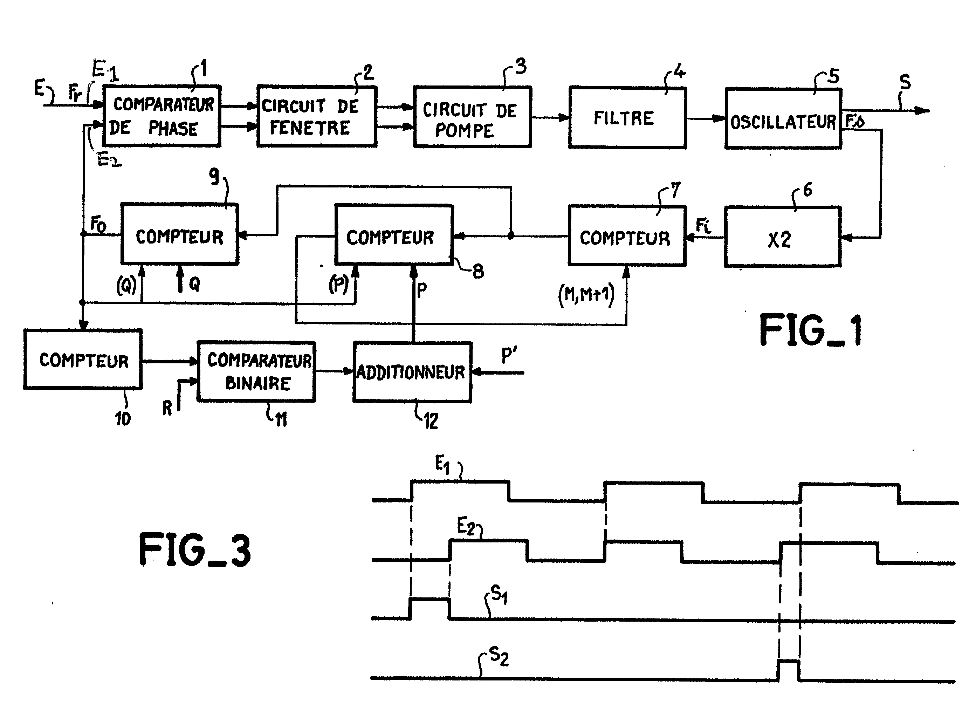

La figure 1 représente un générateur de fréquences selon l'invention. Ce générateur, qui est du type à rang fractionnaire, comporte une entrée, E, sur laquelle est appliqué un signal rectangulaire, de fréquence $Fr = 200$ kHz et une sortie S destinée à fournir un signal sinusoïdal d'une fréquence, Fs, qui peut être choisie entre 30 et 110 MHz avec un pas de 25 kHz. Ce générateur comporte, en série entre son entrée E et sa sortie S:

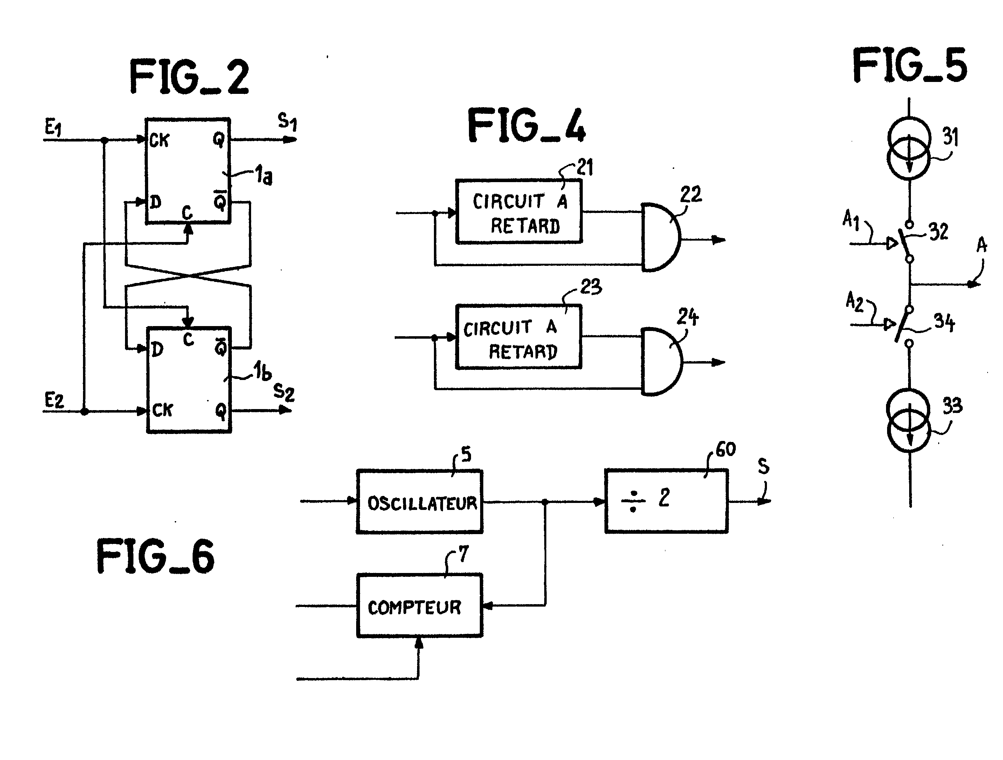

- un comparateur de phase 1 à deux entrées et deux sorties dont la première entrée constitue l'entrée E du générateur; ce circuit sera expliqué à l'aide des figures 2 et 3,
- un circuit de fenêtre, 2, à deux entrées et deux sorties, dont le deux entrées sont respectivement connectées aux deux sorties du comparateur de phase 1 ; la figure 4 montrera un schéma de ce circuit de fenêtre,
- un circuit de pompe de courant, 3, à deux entrées et une sortie, dont les deux entrées sont respectivement reliées aux deux sorties du circuit de fenêtre 2 ; un schéma de ce circuit sera donné à l'aide de la figure 5,
- un filtre, 4, qui a une entrée reliée à la sortie du circuit de pompe, 3, et une sortie ; ce filtre est un filtre de boucle classique du type passe-bas, à deux pôles, totalement passif,
- et un oscillateur, 5, susceptible d'être commandé en tension entre 30 et 110 MHz, ayant une entrée de commande connectée à la sortie du filtre 4 ; cet oscillateur comporte deux séparateurs de sortie dont l'un constitue la sortie S du générateur de fréquences et dont l'autre constitue une sortie de rebouclage.

Le générateur selon la figure 1 comporte également, en série entre la sortie de rebouclage et la seconde entrée du comparateur de phase 1 : un multiplicateur de fréquences par deux, 6, suivi d'un diviseur à rang variable 7-8-9 comportant un circuit prédiviseur, 7, lui-même suivi d'un circuit de division à rang variable, 8-9 qui permet d'effectuer une division de fréquence à rang fractionnaire.

Le circuit prédiviseur 7 est un compteur à deux modulos M et M+1 (avec $M = 10$ dans l'exemple décrit), qui a une entrée de comptage reliée à la sortie du multiplicateur 6 et une entrée de commande pour commander les valeurs $M + 1$ et M du modulo.

Le circuit de division à rang variable 8-9 comporte deux compteurs 8 et 9, du type compteurs-décompteurs synchrones qui décomptent respective-

ment d'une valeur P à zéro et d'une valeur Q à zéro, ces valeurs P et Q étant des valeurs chargées dans les compteurs à l'aide de signaux appliqués sur les entrées symbolisées par des conducteurs d'entrée en trait fort . Le signal de fin de comptage (passage à zéro) du compteur 9 sert de signal de commande de chargement des compteurs 8 et 9, respectivement à P et Q. Le signal de fin de comptage du compteur 8 sert de signal de commande de passage d'une division modulo M+1 à une division modulo M du prédiviseur 7 ; le retour à une division modulo M + 1 est produit par le rechargement du compteur 8 à la valeur P. Dans l'utilisation, qui est faite du générateur décrit, P est compris entre 0 et 11 et Q est compris entre 30 et 110.

Pour obtenir le rang fractionnaire, la valeur P choisie est passée périodiquement de P' à P' + 1. A cet effet un compteur 10, utilisé en décompteur, chargé à k = 4 et recevant comme signal de comptage la sortie de fin de comptage du compteur 9, a ses sorties de comptage comparées, dans un comparateur binaire 11, avec un mot de programmation R auquel est attribuée une des valeurs 0, 1, 2 ou 3 ; la sortie du comparateur 11 est reliée à un additionneur 12 qui reçoit, sur une autre entrée, une valeur P', et l'additionneur fournit la valeur P qui est égale à P' + 1 tant que la sortie du compteur 10 est inférieure à R et à P' dans le cas contraire.

A partir d'une fréquence Fi sur l'entrée de son prédiviseur 7, le diviseur à rang variable fournit donc une fréquence Fo telle qu'un cycle complet de comptage,

$$\frac{1}{Fo},$$

corresponde à P périodes de

$$\frac{Fi}{M+1}$$

plus Q-P périodes de

$$\frac{Fi}{M},$$

c'est-à-dire

$$P\frac{M+1}{Fi} + (Q-P)\frac{M}{Fi} = \frac{1}{Fo}$$

ce qui donne Fi = (P + Q.M)Fo.

La synthèse de fréquence par division fractionnaire a pour inconvénient de provoquer une instabilité de phase, ce qui dégrade le spectre proche de la fréquence à obtenir en créant des raies de synthèse. Pour y remédier il est proposé, comme le montre la figure 1, d'utiliser un circuit de fenêtre, 2, dont le rôle est de masquer cette instabilité avant le circuit de pompe, 3, en tronquant la durée de ses signaux d'entrée d'une valeur T ; cette valeur T sera précisée plus loin. Ainsi l'instabilité de phase, due au rang fractionnaire, ne provoque pas de signal de correction sur la tension de boucle et seul un écart de phase dû à un écart de fréquence, provoque une correction. Ainsi le spectre du signal à la fréquence Fs, délivré par l'oscillateur 5, ne comporte pas de raies dues à l'instabilité. Par contre l'existence de cette fenêtre crée une zone de fonctionnement en boucle ouverte, d'où la nécessité d'avoir une fenêtre la plus petite possible. Dans le cas d'utilisation du générateur décrit, et avec Fs = 30 MHz, le rang de division global N du diviseur à rang variable 7-8-9 est

$$N = \frac{Fi}{Fr} = \frac{2Fs}{Fr} = \frac{2 \times 30.10^6}{200.10^3} = 300$$

et un changement du rang de division de N à N + 1 provoque donc un écart de phase :

$$d\varphi = \frac{N+1}{2Fs} - \frac{N}{2fs} = \frac{1}{2Fs} = 16,6 \text{ ns ;}$$

ainsi, pour masquer l'instabilité de phase due à la division fractionnaire, il a été choisi un circuit de fenêtre, 2, dont la largeur de fenêtre, est de 17 ns ; c'est le temps T dont il a été question plus avant. Pour $F_s > 30$ MHz, l'écart de phase étant inférieur à 16,6 ns, la largeur fenêtre pourrait être inférieure à 17 ns mais cela nécessiterait un réglage de cette largeur en fonction de la fréquence Fs désirée.

En ce qui concerne le temps d'acquisition Ta nécessaire pour atteindre une fréquence stable, sachant qu'il faut de l'ordre de cent périodes de comparaison pour verrouiller en phase une boucle à verrouillage de phase (PLL ou phase locked loop dans la littérature anglo-saxonne) du genre de celle qui vient d'être décrite, il faut choisir une fréquence de comparaison, Fr, telle que

$$Ta \geqslant 100\frac{1}{Fc}$$

dans la mesure où, dans l'exemple décrit, un temps d'acquisition inférieur à 800.10⁻⁶s était désiré, cela a donc conduit à prendre

$$Fr \geqslant \frac{100}{Ta} = \frac{10^8}{800} = 125 \text{ kHz}$$

avec un pas de 25 kHz sur la fréquence Fs il y a eu intérêt, dans l'exemple décrit, pour simplifier la division fractionnaire, à prendre Fr = 200 kHz, si bien que, avec un rang fractionnaire de division égal à 4, le pas de synthèse, p, est égal à

$$\frac{Fr}{4} = 50 \text{ kHz ;}$$

cela a conduit, voulant un pas de 25 kHz sur le signal Fs, à intercaler le doubleur de fréquence 6 entre la sortie de l'oscillateur variable 5 et l'entrée du diviseur à rang variable 7-8-9. Il est possible d'envisager le dual de cette solution en utilisant un oscillateur variable, 5, susceptible d'être commandé en tension entre 60 et 220 MHz et un diviseur de fréquence par deux, 60, sur la sortie d'utilisation de l'oscillateur, le multiplicateur 6 de la figure 1 étant remplacé par un court-circuit ; la partie du générateur ainsi modifié est représentée sur la figure 6.

La solution selon la figure 6 a l'avantage d'autoriser un rang fractionnaire de division plus élevé (k = 8) par le phénomène de filtrage numérique du diviseur 60 sur l'instabilité de phase résiduelle du signal de sortie de l'oscillateur ; mais l'oscillateur variable 5 est plus délicat à réaliser et le spectre en bande large du signal de sortie du diviseur 60 est dégradé par rapport au signal obtenu dans l'autre solution.

La figure 2 montre comment est réalisé le comparateur de phase 1 de la figure 1 ; il est constitué par deux bascules de type D, 1a et 1b, dont les entrées de signal logique, D, d'horloge, CK, et de forçage à zéro, C, ainsi que la sortie directe, Q, et inverse, Q̄, sont repérées sur la figure. L'entrée CK de la bascule 1a est reliée à l'entrée C de la bascule 1b pour constituer la première entrée, E1, du comparateur, correspondant à l'accés E de la figure 1 sur lequel est appliqué le signal de comparaison à la fréquence Fr ; de même l'entrée CK de la bascule 1b est reliée à l'entrée C de la bascule 1a pour constituer la seconde entrée, E2, du comparateur sur lequel est appliquée le signal à la fréquence Fo provenant du circuit de division à rang variable 8-9. Les sorties Q̄ des bascules 1a et 1b sont respectivement reliées aux entrées D des bascules 1b et 1a. Quant aux sorties Q des bascules 1a et 1b elles constituent les deux sorties, S1 et S2, du comparateur 1 reliées respectivement aux deux entrées du circuit de fenêtre, 2, de la figure 1.

La figure 3 est un diagramme des temps qui, en fonction de deux signaux rectangulaires, appliqués respectivement sur les entrées E1 et E2 du comparateur de phase selon la figure 2, montre quels sont les signaux obtenus sur les sorties S1 et S2. Sur la sortie S1 apparaît un signal déclenché par le front avant du signal sur l'entrée E1 et qui dure tant que le signal sur l'entrée E2 est à zéro ; de même sur la sortie S2 apparaît un signal déclenché par le front avant du signal sur l'entrée E2 et qui dure tant que le signal sur l'entrée E1 est à zéro.

La figure 4 est un schéma électrique montrant le principe de réalisation du circuit de fenêtre 2 selon la figure 1. Il s'agit de deux montages dont le premier comporte un circuit à retard 21, de 17 ns de temps de retard, et une porte ET, 22, à deux entrées ; l'entrée de ce premier montage, qui est connectée à la sortie S1 du comparateur 1 de la figure 1, est reliée aux deux entrées de la porte 22 respectivement à travers le circuit à retard 21 et par une liaison directe ; quant à la sortie de la porte 22 elle constitue la première sortie du circuit de fenêtre ; le second montage, composé d'un circuit à retard, 23, et d'une porte ET 24, est identique au premier et son entrée est connectée à la sortie S2 du comparateur 1 de la figure 1 tandis que sa sortie constitue la seconde sortie du circuit de fenêtre.

La figure 5 est un schéma de principe montrant comment est réalisé le circuit de pompe, 3, de la figure 1. Il s'agit d'un circuit à deux entrées A1, A2 et une sortie A, dans lequel les signaux appliqués sur les entrées A1 et A2 commandent respectivement la fermeture de deux contacteurs 32 et 34 ayant chacun une première borne reliée à la sortie A ; les secondes bornes de ces contacteurs sont respectivement reliées à deux générateurs de courant branchés de manière à envoyer respectivement, par la sortie A, un courant dans un sens quand le contacteur 32 est fermé et un courant dans le sens opposé quand le contacteur 34 est fermé. Le rôle de ce circuit de pompe est de transformer les signaux logiques, fournis par le circuit de fenêtre, en impulsions de courant qui vont charger ou décharger les condensateurs du filtre de boucle, 4. Dans la réalisation qui a servi d'exemple à cette description les contacteurs 32, 34 du circuit de pompe, 3, étaient constitués respectivement par un transistor NPN et un transistor PNP montés en collecteur commun.

La présente invention n'est pas limitée à l'exemple décrit, c'est ainsi, par exemple, que le circuit de fenêtre peut être disposé après le circuit de pompe pour réduire la durée des impulsions de courant. De même, dans certaines réalisations, le multiplicateur, 6, de la figure 1 peut avoir un rapport de multiplication entier supérieur à 2 et le diviseur, 60, de la figure 6 un rapport de division entier supérieur à 2 ; ce multiplicateur et ce diviseur pouvant d'ailleurs également être employés ni l'un ni l'autre, la sortie de l'oscillateur variable constituant alors la sortie du générateur de fréquences et étant reliée directement à l'entrée du circuit diviseur à rang variable.

## Revendications

1. Générateur de fréquences à variation rapide, du type à division fractionnaire, comportant un comparateur de phase (1) ayant une première entrée (E1) couplée à une entrée (E) de signal de comparaison (Fr) du générateur et une seconde entrée (E2), un oscillateur variable (5) ayant une entrée de commande couplée au comparateur, et une sortie qui constitue la sortie du générateur, et, entre l'oscillateur et la seconde entrée (E2) du comparateur de phase (1), un diviseur à rang variable (7–8–9), caractérisé en ce que, dans le but d'éviter que l'instabilité de phase due à la division fractionnaire dégrade le spectre du signal de sortie du générateur, il comporte, en série entre le comparateur (1) et l'entrée de commande de l'oscillateur (5), un circuit de fenêtre (2) qui tronque la durée de chaque signal fourni par le comparateur (1) d'une valeur T donnée, fonction de la durée (dφ) maximum de l'écart de phase dû à la division fractionnaire dans la bande des fréquences d'utilisation du générateur.

2. Générateur de fréquences selon la revendication 1, caractérisé en ce qu'il comporte un multiplicateur de fréquence par n (n entier supérieur à 1) pour coupler l'oscillateur (5) au diviseur à rang variable (7–8–9).

3. Générateur de fréquences selon la revendication 1, caractérisé en ce qu'il comporte un diviseur de fréquence par n (n entier supérieur à 1) (60) pour coupler l'oscillateur (5) à la sortie du générateur.

**Claims**

1. A quickly variable frequency generator of the fractional division type, comprising a phase comparator (1), a first input (E1) of which is coupled to the comparison signal (Fr) input (E) of the generator, and having a second input (E2), a variable oscillator (5) having a control input which is coupled to the comparator, and an output which constitutes the generator output, and comprising a variable-module divider (7-8-9) which is inserted between the oscillator and the second input (E2) of the phase comparator (1), characterized in that the frequency generator comprises in series between the comparator (1) and the control input of the oscillator (5) a window circuit (2) which truncates the duration of each output signal of the comparator (1) by a given value T which depends on the maximum duration (dφ) of the phase shift due to the fractional division in the operational frequency bandwidth of the generator, in such a way that the phase jitter due to the fractional division does not impair the spectrum of the generator output signal.

2. A frequency generator according to claim 1, characterized in that it comprises a frequency multiplier by the factor n (n being an integer greater than 1) for coupling the oscillator (5) to the variable-module divider (7-8-9).

3. A frequency generator according to claim 1, characterized in that it comprises a frequency divider (60) by n (n being an integer greater than 1) intended to couple the oscillator (5) to the generator output.

**Patentansprüche**

1. Schnell variierbarer Frequenzgenerator vom Fraktional-Teilertyp mit einem Phasenkomparator (1), der mit einem ersten Eingang (E1) an einen Eingang (E) für ein Vergleichssignal (Fr) des Generators angeschlossen ist und der einen zweiten Eingang (E2) besitzt, mit einem verstimmbaren Oszillator (5), der mit einem Steuereingang an den Komparator angeschlossen ist und der einen Ausgang besitzt, welcher den Ausgang des Generators bildet, und mit einem Teiler variablen Mosuls (7-8-9) zwischen dem Oszillator und dem zweiten Eingang (E2) des Phasenkomparators (1), dadurch gekennzeichnet, daß der Frequenzgenerator in Reihe zwischen dem Komparator (1) und dem Steuereingang des Oszillators (5) einen Fensterkreis (2) aufweist, der die Dauer jedes vom Komparator (1) gelieferten Signals um einen gegebenen Wert (T) verkürzt, der von der Höchstdauer (dφ) des Phasenabstands aufgrund der Teilerfunktion im Nutzfrequenzband des Generators abhängt, um zu vermeiden, daß die Phaseninstabilität aufgrund der Teilerfunktion des Spektrum des Ausgangssignals des Generators beeinträchtigt.

2. Frequenzgenerator nach Anspruch 1, dadurch gekennzeichnet, daß er einen Frequenzmultiplikator um den Faktor n aufweist (n ist eine ganze Zahl größer als 1); um den Oszillator (5) mit dem Teiler variablen Moduls (7-8-9) zu koppeln.

3. Frequenzgenerator nach Anspruch 1, dadurch gekennzeichnet, daß er einen Frequenzteiler (60) durch n besitzt (n ist eine ganze Zahl größer als 1), um den Oszillator (5) an den Generatorausgang zu koppeln.

FIG_1

FIG_3

EP 0 218 508 B1

## FIG_2

E1 → CK   Q → S1
           1a
D   C   Q̄

D   C   Q̄
           1b
E2 → CK   Q → S2

## FIG_4

CIRCUIT A RETARD — 21 → 22

CIRCUIT A RETARD — 23 → 24

## FIG_5

31

A1 — 32    A

A2 — 34

33

EP 0 218 508 B1

## FIG_6

OSCILLATEUR — 5 → ÷ 2 — 60 → S

COMPTEUR — 7